# EUROPÄISCHE PATENTSCHRIFT

(11) **EP 3 093 879 B1**
(45) Veröffentlichungstag und Bekanntmachung des Hinweises auf die Patenterteilung: **07.07.2021**
(21) Anmeldenummer: 15167537.8
(22) Anmeldetag: 13.05.2015
(51) Int. Cl.: H01L 21/68, H01L 21/687

(54) **ENDEFFECTOR EINES WAFERHANDLINGSYSTEMS SOWIE WAFERHANDLINGSYSTEM**
END EFFECTOR OF A WAFER HANDLING SYSTEM AND WAFER HANDLING SYSTEM
EFFECTEUR D'UN SYSTÈME DE MANIPULATION DE WAFERS ET SYSTÈME DE MANIPULATION DE WAFERS

(43) Veröffentlichungstag der Anmeldung: 16.11.2016
(73) Patentinhaber: Integrated Dynamics Engineering GmbH, 65479 Raunheim (DE)
(72) Erfinder: Birkner, Andreas, 07743 Jena (DE)
(74) Vertreter: Blumbach · Zinngrebe Patentanwälte PartG mbB

(56) Entgegenhaltungen:
- EP-A2- 1 037 264
- WO-A2-2009/037673

## Beschreibung

### Gebiet der Erfindung

Die Erfindung betrifft den Endeffector eines Waferhandlingsystems. Insbesondere betrifft die Erfindung ein Waferhandlingsystem, welches einen Endeffector umfasst, mittels dessen ein Wafer von einer FOUP auf eine Bearbeitungsstation oder zwischen verschiedenen Bearbeitungsstationen transportiert werden kann. Die Erfindung betrifft des Weiteren ein Verfahren zum Transport eines Wafers unter Verwendung eines erfindungsgemäßen Endeffectors.

### Hintergrund der Erfindung

In Anlagen der Halbleiterindustrie, also insbesondere in Lithographie und Metrology-Anlagen oder Anlagen zur Prozessierung von Wafern ist oft ein sogenanntes Prealignment, also ein Ausrichten, des in die Anlage transportierten Wafers erforderlich. Der Wafer verfügt in der Regel hierzu über mindestens eine Markierung und kann so über eine optisch gesteuerte Handlingeinrichtung ausgerichtet werden, und zwar sowohl rotatorisch als auch in seiner horizontalen Position. Weiter ist in manchen Fällen auch ein vertikales Ausrichten des Wafers erforderlich.

Aus der Praxis bekannte Anlagen sind daher mit einem sogenannten Prealigner versehen, welcher als separate Prozessstation angesehen werden kann, in welcher der Wafer vor weiteren Prozessschritten ausgerichtet wird.

Nachteilig sind der hierfür benötigte Bauraum sowie die mit dem Prealignment des Wafers verbundene längere Prozesszeit.

Die Offenlegungsschrift WO 2009/037673 A2 zeigt einen Endeffector mit einer ausfahrbaren Vakuum-Spannvorrichtung.

### Aufgabe der Erfindung

Der Erfindung liegt demgegenüber die Aufgabe zugrunde, die Ausrichtung des Wafers gegenüber einem Waferhalter weiter zu verbessern.

### Zusammenfassung der Erfindung

Die Aufgabe der Erfindung wird bereits durch einen Endeffector nach Anspruch 1 gelöst.

Bevorzugte Ausführungsformen und Weiterbildungen der Erfindung sind dem Gegenstand der Unteransprüche zu entnehmen.

Die Erfindung betrifft den Endeffector eines Waferhandlingsystems.

Unter einem Endeffector wird das letzte Element einer kinematischen Kette zum Transport und zur Verarbeitung des Wafers verstanden, welches für das Greifen und Halten des Wafers während des Wafer-Transportes zuständig ist. Der Endeffector ist dabei in der Regel dafür zuständig, den Wafer aus einer Ablagebox zu entnehmen und auf die erste Bearbeitungsstation aufzusetzen, oder umgekehrt, oder um den Wafer von einer Arbeitsstation aufzunehmen und auf einer anderen Arbeitsstation aufzusetzen.

Die zu bearbeitenden Wafer liegen hierfür in der Regel in einer als FOUP ausgebildeten Ablagebox, also einem Front Opening Unified Pod, bereit. Es handelt sich dabei um einen nach vorne offenen Einheitsbehälter, in welchem die Wafer in einer Mehrzahl von Einschüben angeordnet sind.

Der Endeffector umfasst einen Waferhalter zur Aufnahme des Wafers. Dieser Waferhalter ist in der Regel an einem bewegbaren Träger angeordnet und wird mittels des Trägers unter den Wafer geführt, um den Wafer greifen zu können. Der Waferhalter umfasst hierfür in der Regel einen oder zwei Finger, die unter den Wafer greifen, es werden jedoch auch andere Formen angewendet, mit denen der Waferhalter der Wafer greift. Die oft verwendeten Waferhalter fixieren den Wafer mittels Luft-Unterdruck. Es gibt aber auch Waferhalter, welche elektrostatisch oder mechanisch arbeiten, beispielsweise mit Kantengreifung arbeiten.

Der Waferhalter umfasst einen integrierten Prealigner.

Unter einem Prealigner gemäß der Erfindung wird insbesondere eine Einrichtung verstanden, mittels welcher der Wafer gegenüber den Fingern des Waferhalter oder gegenüber einem Träger des Endeffectors relativ bewegbar ist. Die Position des Wafers auf dem Waferhalter kann so vom Endeffector selbst verändert werden, um den Wafer im Zuge der Entnahme aus der FOUP ausrichten zu können.

Das Ausrichten kann dabei zumindest teilweise während des Transportes des Wafers von der FOUP auf die erste Bearbeitungsstation erfolgen.

Durch den Endeffector mit integriertem Prealignment kann so auf einen weiteren Prealigner in der Anlage selbst verzichtet werden. Weiter kann ggf. auch die Prozesszeit verkürzt werden, insbesondere dann, wenn das Prealignment zumindest teilweise während des Transportes des Wafers auf die Bearbeitungsstation erfolgt.

Gemäß der Erfindung umfasst der Prealigner eine Zunge, die zwischen den Fingern des Wafers verfahrbar ist.

So kann der Prealigner zwischen den Fingern des Waferhalters von unten an den Wafer gelangen.

Beim Ablegen des Wafers auf eine Auflagestation (beispielsweise eines Wafer-Chucks), welche als erste Bearbeitungsstation ausgebildet sein kann, kann die Zunge zumindest teilweise zwischen den Fingern des Waferhalters nach hinten herausgefahren werden, so dass in der Auflagestation Ausnehmungen nur für die Finger des Waferhalters vorgesehen sein müssen. Da vorher die Zunge als Unterstützung für den Wafer wirken kann, ist es denkbar, die Finger des Waferhalters und damit auch die notwendigen Ausnehmungen auf der Anlagestation schmaler auszugestalten.

Die Zunge ist bei einer Ausführungsform der Erfindung auch vertikal verfahrbar, um den Wafer oder ein weiteres Prealigner-Element, welches mit der Zunge verbunden ist, anheben zu können.

Bei einer anderen Ausführungsform der Erfindung kann die Zunge zum Ausrichten rotatorisch bewegt werden.

Denkbar ist aber auch eine Ausführungsform der Erfindung, bei welcher die Zunge nicht nur in einer horizontalen Richtung verfahrbar ausgebildet ist, sondern bei welcher diese nur ein weiteres Element des Prealigners, wie insbesondere einen Drehteller, trägt.

Vorzugsweise umfasst der Prealigner einen Drehteller, über welchen der Wafer rotatorisch ausgerichtet werden kann. Vorzugsweise ist der Drehteller anhebbar, um den Wafer von den Fingern des Waferhalters abheben und drehen zu können. Eine Anhebbarkeit des Drehtellers kann sowohl über den Drehteller selbst bereitgestellt werden, also über ein Stellelement, was in den Drehteller integriert ist, als auch mittels einer vertikal bewegbaren Zunge, auf welcher der Drehteller angeordnet ist.

Der Prealigner besteht mithin bei einer bevorzugten Ausführungsform der Erfindung aus Zunge und Drehteller.

Es versteht sich, dass der Drehteller eine beliebige Form haben kann, die es erlaubt, den angehobenen Wafer zu drehen. Der Drehteller muss mithin nicht kreisförmig ausgebildet sein.

Die Erfindung betrifft des Weiteren ein Waferhandlingsystem, welches den zuvor beschriebenen Endeffector mit integriertem Prealigner sowie eine Kamera zur Vermessung des vom Endeffector aufgenommenen Wafers umfasst.

Die Kamera kann dabei beispielsweise als Zeilen- oder als Flächenkamera ausgebildet sein.

Bei einer Ausführungsform der Erfindung erfolgt die Vermessung des Wafers mittels einer Zeilenkamera während der Entnahme aus der FOUP. Eine exakte Vermessung des Wafers kann so auf sehr einfache Weise realisiert werden und erfolgt zudem, während dieser ohnehin vom Endeffector transportiert wird. Es sind natürlich auch andere Positionen für die Zeilenkamera zur Vermessung des Wafers möglich.

Die Erfindung betrifft des Weiteren ein Verfahren, bei dem vorstehend beschriebener Endeffector verwendet wird und bei welchem der Wafer mittels des Endeffectors auf eine Ablagestation, welche insbesondere als erste Bearbeitungsstation ausgebildet ist, transportiert wird.

Dabei wird der Wafer vorzugsweise zumindest rotatorisch ausgerichtet, insbesondere mittels eines Drehtellers, der Teil des eingangs beschriebenen Prealigners ist.

Der Wafer kann des Weiteren aber auch teilweise mit dem Endeffector selbst ausgerichtet werden. Insbesondere ist vorgesehen, dass Prealigner und Endeffector beim Ausrichten des Wafers zusammenwirken.

Der Endeffector umfasst in der Regel einen Waferhalter-Träger. Der Träger kann entlang einer vertikalen Achse rotierbar sein, wodurch der Endeffector den Wafer durch eine Drehung transportieren kann.

Weiter kann der Endeffektor auch linear in einer horizontalen Richtung verfahrbar sein, etwa um den Waferhalter in die FOUP oder in die erste Auflagestation einzufahren. Diese Linearbewegung kann auch mittels einem an dem Träger linear verfahrbaren Waferhalter erreicht werden.

Mithin kann in der horizontalen Ebene über die Linearbewegung oder andere Bewegung des Endeffectors der Wafer ausgerichtet werden. Des Weiteren ist im Rahmen der Drehbewegung durch eine Veränderung des Winkels eine Ausrichtung auch senkrecht zu dieser linearen Richtung möglich.

Weiter kann der Endeffector Teil einer Automatisierungseinrichtung, beispielsweise Teil eines Roboters, sein. Über diese kann der gesamte Endeffector linear oder rotatorisch bewegt werden.

Der Prealigner braucht den Wafer daher, wie es bei einer Ausführungsform der Erfindung vorgesehen ist, nur rotatorisch auszurichten, während das weitere Ausrichten über die Bewegung des Endeffectors selbst erfolgt.

Denkbar ist aber auch insbesondere, die vertikal verfahrbare Zunge dazu zu verwenden, um den Wafer in einer linearen Richtung auf den Fingern des Waferhalters auszurichten.

Weiter ist es möglich, während des Transportierens und/oder Vermessens des Wafers den Prealigner zu verwenden, um den Wafer vertikal auszurichten. Insbesondere kann mittels des Prealigners die Durchbiegung des Wafers reduziert werden, was auch für Anwendungen, in denen die Schärfentiefe eine Rolle spielt, interessant ist, da die diesbezüglichen Sensoren oft eine nur geringe Tiefenschärfe aufweisen.

### Kurzbeschreibung der Zeichnungen

Der Gegenstand der Erfindung soll im Folgenden Bezug nehmend auf schematisch dargestellte Ausführungsbeispiele anhand der Zeichnungen Fig. 1a bis Fig. 2h näher erläutert werden.
Fig. 1a bis Fig. 1c zeigen einen Endeffector mit integriertem Prealigner in verschiedenen Positionen.
Fig. 2a bis Fig. 2h zeigen ein Waferhandlingsystem, welches einen Endeffector, eine Kamera, eine FOUP und eine Ablagestation umfasst, in verschiedenen Prozessschritten.
Fig. 3a und Fig. 3b zeigen eine Ausführungsform eines Endeffectors mit verschwenkbarer Zunge.

### Detaillierte Beschreibung der Zeichnungen

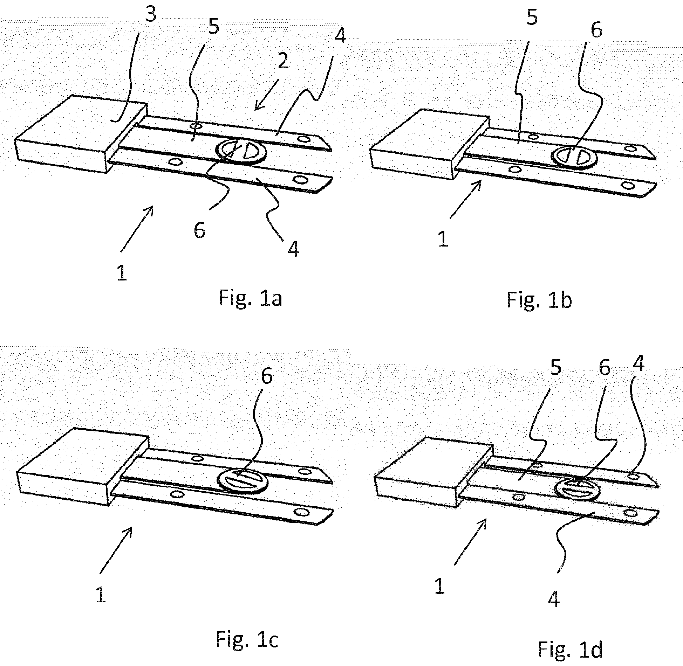

Fig. 1a bis Fig. 1c zeigen eine schematische, perspektivische Ansicht des Endeffectors 1 mit einem integrierten Prealigner.

Der Endeffector 1 umfasst, wie insbesondere in Fig. 1a gut zu erkennen ist, einen Träger 3, welcher einen Waferhalter 2 zum Aufnehmen eines Wafers umfasst.

Der Waferhalter 2 umfasst zwei am Träger angeordnete Finger 4, welche dem Aufnehmen und Halten des Wafers dienen.

Dies kann beispielsweise über in den Fingern integrierte Kanäle mit einer Ansaugvorrichtung erfolgen.

Der Träger 3 ist bei dieser Ausführungsform der Erfindung sowohl in einer linearen horizontalen Richtung als auch rotatorisch um eine vertikale Achse bewegbar. Vorzugsweise ist der Träger auch linear in vertikaler Richtung bewegbar, etwa um die verschiedenen Einschübe der FOUP anzufahren.

Gemäß der Erfindung umfasst der Endeffector 1 einen integrierten Prealigner, welcher in diesem Ausführungsbeispiel eine zwischen den Fingern 4 des Waferhalters angeordnete Zunge 5 sowie einen vorn an der Zunge 5 angeordneten Drehteller 6 umfasst.

Wie nunmehr in Fig. 1b dargestellt, kann die Zunge 5 und damit auch der Drehteller 6 vertikal nach oben verfahren werden. Ein auf dem Drehteller 6 angeordneter Wafer würde nunmehr angehoben und könnte sodann mittels des Drehtellers, wie dies in Fig. 1c dargestellt ist, relativ zu den Fingern des Waferhalters bewegt werden.

Nach Abschluss der so erfolgten rotatorischen Ausrichtung des Wafers wird, wie in Fig. 1d dargestellt, die Zunge 5 wieder vertikal nach unten bewegt, wodurch ein auf dem Drehteller 6 liegender Wafer wieder auf den Fingern 4 des Waferhalters abgelegt wird.

Es versteht sich, dass diese Vertikalbewegung bei anderen Ausführungsformen der Erfindung auch über einen Drehteller realisiert werden kann, welcher selbst vertikal verfahrbar ist. Denkbar ist aber auch, die Zunge eine Schwenkbewegung ausführen zu lassen, um den Drehteller vertikal anzuheben.

Weiter ist auch denkbar, dass die Zunge auch in der horizontalen Ebene verschwenkt werden kann, um den Wafer gegenüber den Fingern des Waferhalters lateral auszurichten.

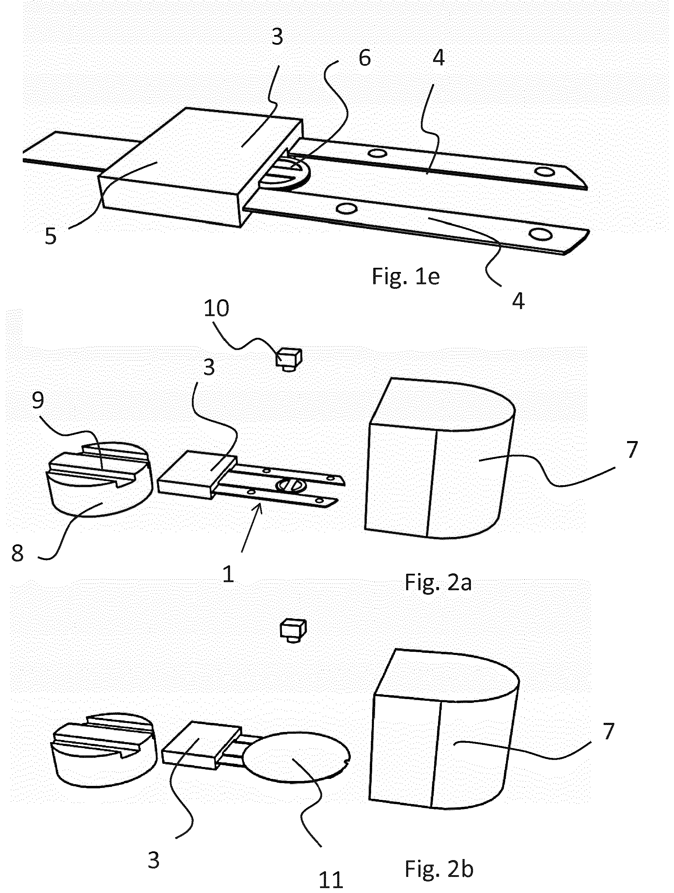

Weiter ist die Zunge vorzugsweise linear in den Träger einfahrbar. Dies ist in Fig. 1e dargestellt.

Die einfahrbare Zunge dient dazu, auf der Ablagestation die Größe der Ausnehmungen für den Endeffector zu verringern und die Auflagefläche des Wafers zu vergrößern und damit seine Durchbiegung zu reduzieren. Insbesondere bei Anwendungen, in denen die Schärfentiefe eines darüberliegenden Messsystems keine Rolle spielt, braucht die Zunge aber nicht einfahrbar ausgestaltet zu sein.

Fig. 1e zeigt, dass die Zunge 5 linear nach hinten in den Träger 3 eingefahren werden kann und damit auch den Drehteller zwischen den Fingern 4 des Waferhalters zurückzieht. Die Zunge wird dazu vertikal auf eine Position unterhalb der Finger 4 gefahren, so dass der Drehteller 6 keine Berührung mit der Unterseite des Wafers hat.

Ein aufliegender Wafer sitzt nunmehr nur noch auf den Fingern 4 des Waferhalters. Dies ist insbesondere vorgesehen, um den Wafer mittels des Waferhalters in eine Bearbeitungsstation einzufahren, in welcher Ausnehmungen zur Aufnahme der Finger 4 des Waferhalters vorhanden sein müssen.

Denkbar ist aber auch, dass die Linearbewegung der Zunge 5 genutzt wird, um den Wafer im Rahmen eines Prealignments gegenüber den Fingern 4 des Waferhalters auszurichten.

Fig. 2a bis Fig. 2h zeigen eine schematische Ansicht eines Waferhandlingsystems, welches, wie insbesondere in Fig. 2a dargestellt, den zuvor beschriebenen Endeffektor 1 sowie eine FOUP umfasst, aus welcher Wafer vom Endeffector 1 entnommen und auf eine Auflagestation 8 verbracht werden.

Hierzu ist der Träger 3 des Endeffectors entlang einer vertikalen Achse drehbar.

Weiter ist der Träger auch linear in vertikaler Richtung sowie linear in horizontaler Richtung, und zwar in Richtung der Finger des Prealigners bewegbar.

Die Auflagenstation 8, in welcher beispielsweise ein erster Bearbeitungsschritt erfolgt, umfasst als Nuten ausgestaltete Ausnehmungen 9, welche die Finger des Waferhalters beim Ablegen aufnehmen.

Weiter umfasst das Handlingsystem eine Kamera 10, mit welcher ein auf dem Waferhalter aufliegender Wafer vermessen werden kann.

Wie in Fig. 2b dargestellt, wird ein Wafer 11 durch eine Bewegung des Trägers aus der FOUP 7 herausgefahren.

Hierzu fährt der Träger 3 die Finger des Waferhalters unter einen in einem Einschub der FOUP 7 angeordneten Wafer.

Die Finger des Waferhalters werden sodann mittels des Trägers 3 angehoben und der Wafer wird durch eine Linearbewegung des Trägers 3 aus der FOUP herausgefahren und kommt in der hier dargestellten Position an.

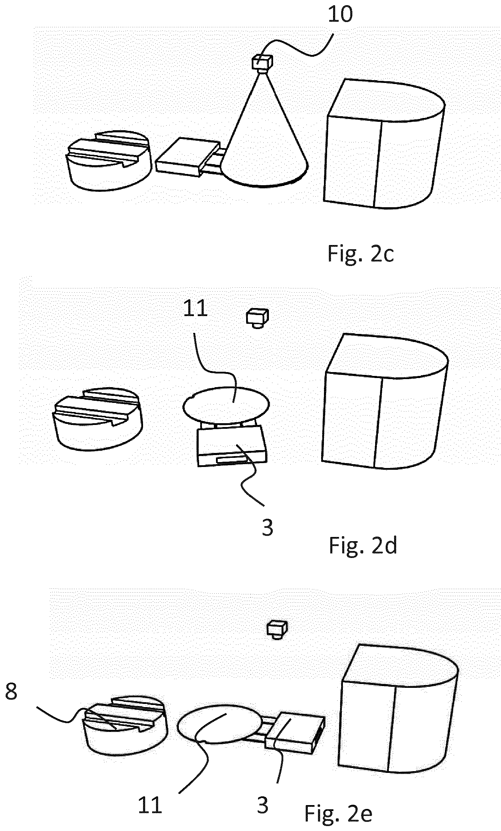

Sodann wird, wie in Fig. 2c dargestellt, der Wafer mittels der Kamera 10 vermessen. Es handelt sich in diesem Ausführungsbeispiel bei der Kamera 10 um eine Flächenkamera. Der im Bild dargestellte Kegel unter der Kamera 10 stellt das Bildfeld der Kamera dar. Es versteht sich, dass eine hier nicht gargestellte Beleuchtung eingesetzt werden kann, um das für die Bildaufnahme benötigte Licht bereitzustellen.

Denkbar ist aber auch, eine Zeilenkamera zu verwenden, mittels welcher der Wafer während seines Herausfahrens aus der FOUP 7 oder während einer anderen Relativbewegung des Wäfers zur Zeilenkamera vermessen wird.

Sodann wird der Wafer 11, wie in Fig. 2d und Fig. 2e dargestellt, durch eine Drehbewegung des Trägers 3 um, beispielsweise um etwa 180°, in Richtung der Auflagestation 8 ausgerichtet. Der Winkel hängt von der konkreten Konfiguration des Handlingsystems ab und kann auch einen anderen Wert haben.

Während dieses Bewegens kann gleichzeitig, wie unter Bezugnahme auf Fig. 1a bis Fig. 1d beschrieben wurde, der Wafer 11 auf dem Waferhalter mittels des Prealigners ausgerichtet werden.

Es ist aber auch denkbar, dass das Prealignment in einem gesonderten Prozessschritt erfolgt, etwa nach der Vermessung mittels der Kamera (dargestellt in Fig. 2c) oder erst nachdem der Wafer 11 (wie in Fig. 2e dargestellt) in Richtung der Aufnahmestation 8 zeigt.

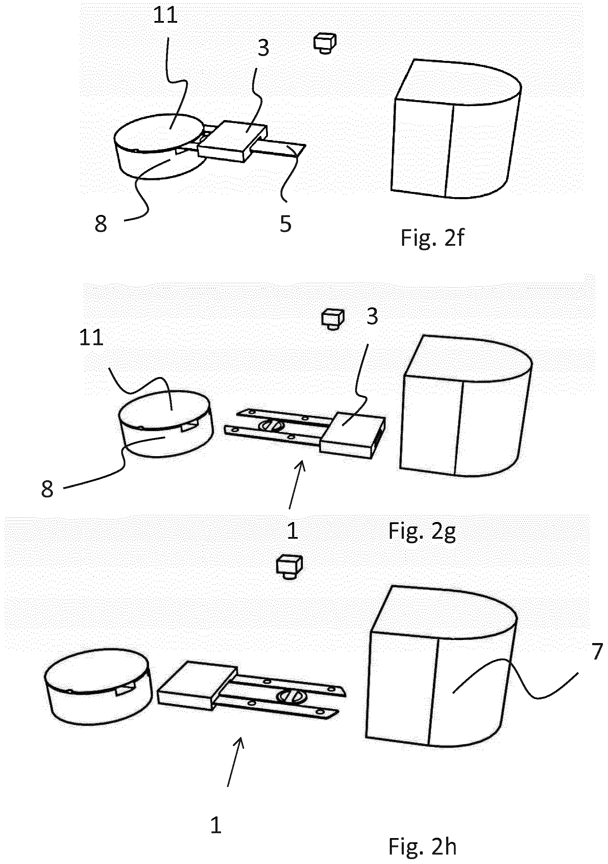

Fig. 2f zeigt, wie der Wafer 11 nunmehr über eine Linearbewegung des Trägers 3 auf die Auflagestation 8 gesetzt wird.

Dabei wird die Zunge 5 in diesem Ausführungsbeispiel nach hinten gefahren, so dass der Bereich zwischen den Fingern des Waferhalters freigegeben ist und für die Auflagestation 8 die Zunge 5 keine oder nur eine kleinere Ausnehmung aufweisen muss.

Im Rahmen des Prealignments des Wafers ist es nunmehr denkbar, über die Linearbewegung des Trägers 3 zur Aufnahmestation 8 den Wafer 11 in dieser horizontalen Richtung auszurichten.

Weiter kann über die in Fig. 2d und 2e dargestellte Drehbewegung des Endeffectors die Position des Wafers auch senkrecht zu dieser Linearbewegung ausgerichtet werden. Der Prealigner wäre in diesem Falle nur für das rotatorische Ausrichten des Wafers 11 notwendig.

Fig. 2g zeigt, wie der Endeffector 1 durch Runterfahren des Trägers 3 sowie eine Linearbewegung aus der Auflagestation 8 herausgefahren wurde.

Der Endeffektor 1 wird nunmehr wieder, wie in Fig. 2h dargestellt, gedreht, so dass die Finger des Waferhalters in Richtung der FOUP zeigen. Der Endeffector 1 ist nunmehr bereit, einen weiteren Wafer aus der FOUP 7 herauszufahren.

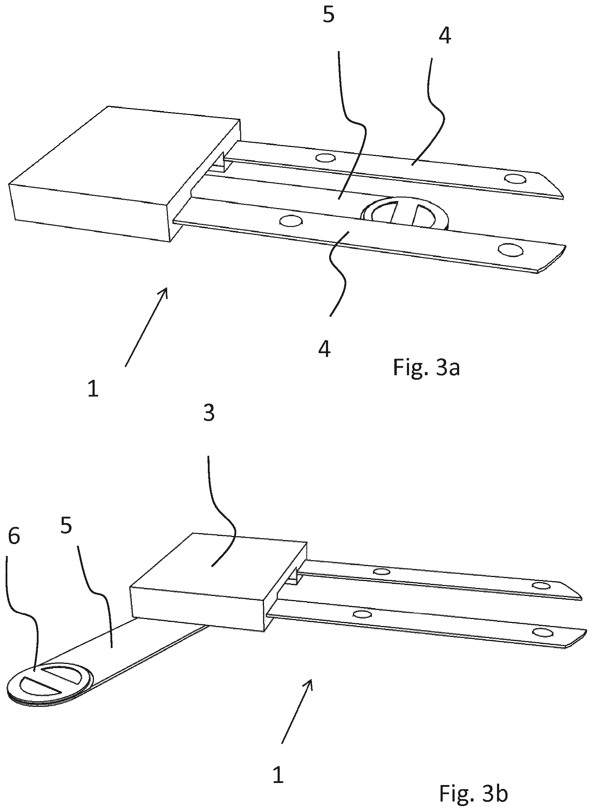

Anstelle der linear herausfahrbaren Zunge kann auch eine drehbare Zunge verwendet werden: Vor Ablage des Wafers auf der Ablagestation wird die Zunge zwischen den Fingern abgesenkt und dann der Finger seitlich weggedreht. Der Vorteil liegt in einer einfacheren technischen Ausführung, der Nachteil in einem erhöhten seitlichen Platzbedarf. Eine derartige Ausführungsform ist in Fig. 3a und Fig. 3b dargestellt.

Wie in Fig. 3a dargestellt, kann die Zunge 5 zwischen den Fingern 4 des Endeffectors 1 herunter gefahren werden.

Sodann wird, wie in Fig. 3b dargestellt, die Zunge 5 am Träger 3 zur Seite geschwenkt. Auch bei dieser Ausführungsform umfasst die Zunge 5 einen Drehteller 6. Weiterhin kann gemäß einer nicht in den Zeichnungen dargestellten nicht erfindungsgemäßen Ausführungsform auf die Finger des Waferhalters verzichtet werden: Der Wafer wird nur durch die Zunge aufgenommen, auf der Zunge gedreht und auf eine Ablagestation abgelegt. Dabei braucht die Zunge keine vertikale Bewegung im Endeffector auszuführen, da keine Relativbewegung zwischen Zunge und Fingern notwendig ist. Durch eine Integration des Prealignments im Endeffector kann der Aufbau von Anlagen der Halbleiterindustrie, also insbesondere in Lithographie und Metrology-Anlagen oder Anlagen zur Prozessierung von Wafern vereinfacht werden. Weiter können Prozesszeiten verkürzt werden.

### Bezugszeichenliste

- 1: Endeffector
- 2: Waferhalter
- 3: Träger
- 4: Finger
- 5: Zunge
- 6: Drehteller
- 7: FOUP
- 8: Auflagestation
- 9: Ausnehmung
- 10: Kamera
- 11: Wafer

## Patentansprüche

1. Endeffector (1) eines Waferhandlingsystems, umfassend einen Träger (3), der einen Waferhalter (2) zur Aufnahme eines Wafers (11) umfasst, wobei der Waferhalter (2) einen integrierten Prealigner umfasst, **dadurch gekennzeichnet, dass** der Prealigner eine verfahrbare Zunge (5) umfasst, die zwischen Fingern (4) des Waferhalters (2) angeordnet ist, und wobei die Zunge zumindest teilweise zwischen den Fingern (4) des Waferhalters (2) linear nach hinten in den Träger (3) eingefahren werden kann.

2. Endeffector nach Anspruch 1, **dadurch gekennzeichnet, dass** die Zunge (5) linear verfahrbar oder verschwenkbar ist.

3. Endeffector nach einem der vorstehenden Ansprüche, **dadurch gekennzeichnet, dass** ein Wafer mittels des Prealigners drehbar ist, insbesondere mittels eines Drehtellers (6).

4. Endeffector nach Anspruch 3, **dadurch gekennzeichnet, dass** der Prealigner eine vertikal verfahrbare Waferauflagefläche umfasst, insbesondere ausgebildet als vertikal verfahrbarer Drehteller (6).

5. Waferhandlingsystem, umfassend einen Endeffector (1) nach einem der vorstehenden Ansprüche sowie eine Kamera (10) zur Vermessung eines aufgenommenen Wafers (11) .

6. Waferhandlingsystem nach Anspruch 5, **dadurch gekennzeichnet, dass** die Kamera (10) als Flächen- oder Zeilenkamera ausgebildet ist.

7. Waferhandlingsystem nach einem der vorstehenden Ansprüche, weiter umfassend eine FOUP (7) und eine Ablagestation (8), wobei ein Wafer (11) mittels des Endeffectors (1) aus der FOUP (7) auf die Ablagestation (8) transportierbar ist.

8. Verfahren zum Transport eines Wafers unter Verwendung eines Endeffectors nach einem der vorstehenden Ansprüche, wobei der Wafer (11) mittels des Endeffectors (1) auf eine Ablagestation (8) transportiert wird.

9. Verfahren nach Anspruch 8, **dadurch gekennzeichnet, dass** der Wafer (11) rotatorisch ausgerichtet wird, insbesondere mittels eines Drehtellers (6) des Prealigners.

10. Verfahren nach einem der vorstehenden Ansprüche, **dadurch gekennzeichnet**, **dadurch gekennzeichnet, dass** der Wafer (11) in einer horizontalen Ebene ausgerichtet wird.

11. Verfahren nach Anspruch 10, **dadurch gekennzeichnet, dass** der Wafer (11) mittels des Prealigners und/oder mittels einer Bewegung des Endeffectors (1) in einer horizontalen Ebene ausgerichtet wird.

12. Verfahren nach einem der vorstehenden Ansprüche, **dadurch gekennzeichnet, dass** der Wafer (11) mittels eines Prealigners vertikal ausgerichtet wird.

13. Verfahren nach einem der vorstehenden Ansprüche, **dadurch gekennzeichnet, dass** der Wafer (11) bei der Entnahme aus einer FOUP (7) vermessen wird, insbesondere mittels einer Zeilenkamera.

14. Verfahren nach einem der vorstehenden Ansprüche, **dadurch gekennzeichnet, dass** der Wafer (11) während des Transports von einer FOUP (11) zu einer Ablagestation (8) und/oder beim Ablegen auf einer Ablagestation (8) und/oder während des Transports zwischen zwei Ablagestationen und/oder während des Transports von einer Ablagestation zu einer FOUP mittels des Prealigners ausgerichtet wird.

## Claims

1. An end effector (1) of a wafer handling system, comprising a carrier (3) which comprises a wafer holder (2) for receiving a wafer (11), the wafer holder (2) comprising an integrated prealigner;
**characterized in that**
said prealigner comprises a movable tongue (5) which is arranged between fingers (4) of the wafer holder (2); and
wherein the tongue can be linearly retracted backwards, at least partially, into the carrier (3), between the fingers (4) of the wafer holder (2).

2. The end effector according to claim 1,
**characterized in that** the tongue (5) can be displaced linearly or pivoted.

3. The end effector according to any one of the preceding claims,
**characterized in that** a wafer can be rotated by the prealigner, in particular by a turntable (6).

4. The end effector according to claim 3,
**characterized in that** the prealigner comprises a vertically displaceable wafer support surface, in particular in the form of a vertically displaceable turntable (6).

5. A wafer handling system, comprising an end effector (1) according to any one of the preceding claims, and a camera (10) for measuring a received wafer (11).

6. The wafer handling system according to claim 5,
**characterized in that** the camera (10) is in the form of an area scan camera or line scan camera.

7. The wafer handling system according to any one of the preceding claims,
further comprising a FOUP (7) and a storage station (8), wherein the end effector (1) is operable to transfer a wafer (11) from the FOUP (7) to the storage station (8).

8. A method for transferring a wafer using an end effector according to any one of the preceding claims, wherein the wafer (11) is transferred to a storage station (8) by the end effector (1).

9. The method according to claim 8,
**characterized in that** the wafer (11) is aligned by being rotated, in particular by a turntable (6) of the prealigner.

10. The method according to any one of the preceding claims,
**characterized in that** the wafer (11) is aligned in a horizontal plane.

11. The method according to claim 10,
**characterized in that** the wafer (11) is aligned in a horizontal plane by the prealigner and/or by a movement of the end effector (1).

12. The method according to any one of the preceding claims,
**characterized in that** the wafer (11) is aligned vertically by a prealigner.

13. The method according to any one of the preceding claims,
**characterized in that** the wafer (11) is measured, in particular using a line scan camera, when being removed from a FOUP (7).

14. The method according to any one of the preceding claims,
**characterized in that** the wafer (11) is aligned by the prealigner when being transferred from a FOUP (11) to a storage station (8) and/or when being deposited on a storage station (8) and/or when being transferred between two storage stations and/or when being transferred from a storage station to a FOUP.

## Revendications

1. Effecteur (1) d'un système de manipulation de plaques, comprenant un support (3) qui comporte un moyen de maintien de plaque (2) destiné à accueillir une plaque (11), le moyen de maintien de plaque (2) comprenant un élément de pré-alignement intégré, **caractérisé en ce que** l'élément de pré-alignement comprend une languette (5) déplaçable qui est disposée entre des doigts (4) du moyen de maintien de plaque (2), et la languette pouvant être rentrée au moins en partie entre les doigts (4) du moyen de maintien de plaque (2), de façon linéaire vers l'arrière dans le support (3).

2. Effecteur selon la revendication 1, **caractérisé en ce que** la languette (5) peut être déplacée de façon linéaire ou peut être pivotée.

3. Effecteur selon l'une des revendications précédentes, **caractérisé en ce qu'**une plaque peut être tournée au moyen de l'élément de pré-alignement, notamment au moyen d'un plateau tournant (6).

4. Effecteur selon la revendication 3, **caractérisé en ce que** l'élément de pré-alignement comprend une surface d'appui de plaque qui peut être déplacée verticalement et est notamment réalisée sous la forme d'un plateau tournant (6) à déplacement vertical.

5. Système de manipulation de plaque, comprenant un effecteur (11) selon l'une des revendications précédentes, ainsi qu'une caméra (10) destinée à mesurer une plaque (11) enregistrée.

6. Système de manipulation de plaque selon la revendication 5, **caractérisé en ce que** la caméra (10) est réalisée sous forme de caméra matricielle ou linéaire.

7. Système de manipulation de plaque selon l'une des revendications précédentes, comprenant en outre un FOUP (7) et un poste de dépôt de plaque, une plaquer (11) pouvant être transportée au moyen de l'effecteur (1) hors du FOUP (7) et sur le poste de dépôt (8).

8. Procédé de transport d'une plaque en utilisant un effecteur selon l'une des revendications précédentes, la plaque (11) étant transportée sur un poste de dépôt (8) au moyen de l'effecteur (1).

9. Procédé selon la revendication 8, **caractérisé en ce que** la plaque (11) est alignée de manière rotatoire, en particulier au moyen d'un plateau tournant (6) de l'élément de pré-alignement.

10. Procédé selon l'une des revendications précédentes, **caractérisé en ce que** la plaque (11) est alignée dans un plan horizontal.

11. Procédé selon la revendication 10, **caractérisé en ce que** la plaque (11) est orientée dans un plan horizontal au moyen de l'élément de pré-alignement et/ou au moyen d'un mouvement de l'effecteur (1).

12. Procédé selon l'une des revendications précédentes, **caractérisé en ce que** la plaque (11) est alignée verticalement au moyen d'un élément de pré-alignement.

13. Procédé selon l'une des revendications précédentes, **caractérisé en ce que** la plaque (11) est mesurée lors du prélèvement dans un FOUP (7), en particulier au moyen d'une caméra linéaire.

14. Procédé selon l'une des revendications précédentes, **caractérisé en ce que** la plaque (11) est alignée au moyen de l'élément de pré-alignement pendant le transport depuis un FOUP (11) vers un poste de dépôt (8) et/ou lors du dépôt sur un poste de dépôt (8) et/ou pendant le transport entre deux postes de dépôt et/ou pendant le transport depuis un poste de dépôt vers un FOUP.
